# EUROPÄISCHE PATENTSCHRIFT

(11) **EP 2 855 343 B1**
(45) Veröffentlichungstag und Bekanntmachung des Hinweises auf die Patenterteilung: **27.04.2016**
(21) Anmeldenummer: 13726113.7
(22) Anmeldetag: 24.05.2013
(51) Int. Cl.: B81B 3/00

(54) **VERFAHREN ZUR FIXIERUNG EINER BEWEGLICHEN KOMPONENTE EINES MIKROMECHANISCHEN BAUELEMENTES**
METHOD FOR FIXATION OF A MOVABLE COMPONENT OF A MICRO-MECHANICAL STRUCTURAL ELEMENT
PROCÉDÉ DE FIXATION D'UN COMPOSANT MOBILE D'UN ÉLÉMENT DE CONSTRUCTION MICROMÉCANIQUE

(30) Priorität: 29.05.2012 DE 102012010549
(43) Veröffentlichungstag der Anmeldung: 08.04.2015
(73) Patentinhaber: Fraunhofer-Gesellschaft zur Förderung der angewandten Forschung e.V., 80686 München (DE); Technische Universität Chemnitz, 09111 Chemnitz (DE)
(72) Erfinder: BERTZ, Andreas, 09123 Chemnitz (DE); SCHULZ, Stefan, E., 09120 Chemnitz (DE)
(74) Vertreter: Gagel, Roland
(86) Internationale Anmeldenummer: PCT/EP2013/001543
(87) Internationale Veröffentlichungsnummer: WO 2013/178343

(56) Entgegenhaltungen:
- WO-A2-03/043189
- DE-B4-102004 058 103
- US-A1- 2007 230 241

## Beschreibung

### Technisches Anwendungsgebiet

Die vorliegende Erfindung betrifft ein Verfahren zur Fixierung einer beweglichen Komponente eines mikromechanischen Bauelementes an einer weiteren feststehenden oder beweglichen Komponente des Bauelementes. Das Verfahren betrifft auch ein mikromechanisches Bauelement, das durch die Anwendung des Verfahrens erhalten wird.

Mikromechanische Bauelemente werden heutzutage für viele Anwendungen eingesetzt, bei denen miniaturisierte, mechanische oder elektromechanische Funktionen auf kleinstem Raum erforderlich sind. Bei einer Vielzahl von mechanischen Mikrosystemen für Sensor- und Aktoranwendungen weisen die mikromechanischen Bauelemente mindestens ein beweglich ausgelegtes Strukturelement auf, das über eine oder mehrere elastische Verbindungen an einem Grundkörper oder einer anderen feststehenden Struktur des Bauelementes befestigt ist. Beispiele sind kapazitive Beschleunigungssensoren oder elektrostatische Aktoren für Schalt- oder Regelvorgänge. Bei derartigen Bauelementen werden kleinste Spaltbreiten zwischen dem beweglichen Strukturelement und einem feststehenden Gegenelement bei möglichst großer Elektrodenfläche an den jeweils gegenüber liegenden Elementen benötigt.

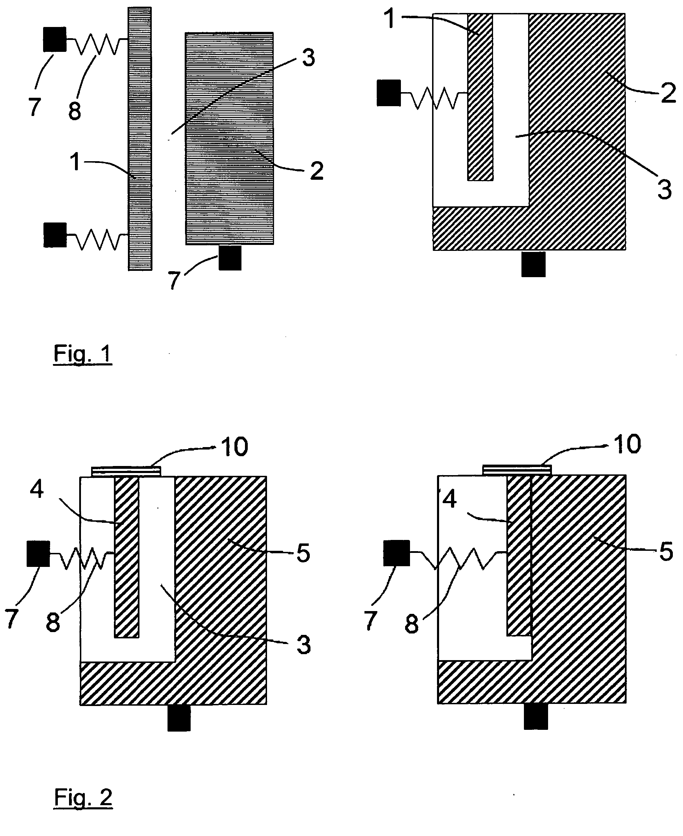

Figur 1 zeigt zur Veranschaulichung eine Struktur eines mikromechanischen Bauelementes mit kapazitivem Wandlerprinzip in Draufsicht und im Querschnitt. Das feststehende Strukturelement 2 stellt eine Elektrode dar, die fest mit dem nicht dargestellten Grundkörper verbunden ist. Ein bewegliches Strukturelement 1, das ebenfalls als Elektrode ausgebildet ist, ist über zwei Federelemente 8 an einer Ankerstruktur 7 aufgehängt, die fest mit dem Grundkörper verbunden ist. Die beiden Elektroden bzw. Strukturelemente 1, 2 sind durch einen Spalt 3 voneinander beabstandet, dessen minimale Spaltbreite durch die Herstellungstechnologie begrenzt ist. Bei der Herstellung eines derartigen Bauelementes lassen sich derartige Spalte als Gräben in einem Substrat nur mit einem begrenzten Aspektverhältnis erzeugen. Unter dem Aspektverhältnis versteht man das Verhältnis von Grabentiefe zu Grabenbreite, im vorliegenden Beispiel das Verhältnis zwischen Ätztiefe des Spaltes 3 zur Spaltbreite. Die Ätztiefe ist in der Figur 1b erkennbar. Zur Vergrößerung der Elektrodenflächen sind die sich gegenüber liegenden beweglichen und feststehenden Strukturelemente häufig mit Kammstrukturen versehen, die unter Wahrung des Spaltabstandes ineinander greifen.

Die technologischen Möglichkeiten zur Maximierung des Aspektverhältnisses bei der Herstellung mikromechanischer Bauelemente lassen kaum bzw. mit sehr hohem Aufwand eine weitere Verringerung der Spaltbreite zu. Daher wurde und wird nach Lösungen gesucht, den elektrisch wirksamen Spalt zwischen den Strukturelementen erst nach der Herstellung der Grundstrukturen des mikromechanischen Bauelementes zu verringern.

Eine derartige nachträgliche Spalteinstellung umgeht auch das Problem, dass zur Erreichung einer hohen Strukturqualität bei der Herstellung eines mikromechanischen Bauelementes, besonders bei Strukturen mit sehr hohem Aspektverhältnis, die Grabenbreiten aus technologischer Sicht möglichst im gesamten Bauelement gleich sein sollten. Bedingt durch Transportphänomene (Teilchendiffusion in der Gasphase bei Plasma-basierten Ätzprozessen) können ansonsten die Ätzgeschwindigkeiten sehr unterschiedlich sein, was zu verschiedensten Strukturtoleranzen führt. Andererseits sind funktionsbedingt für mikromechanische Sensoren bzw. Aktoren oftmals sehr unterschiedliche Spaltbreiten in einem Bauelement gewünscht. Eine bewegliche Elektrodenplatte beispielsweise, die elektrostatisch gegen eine feststehende Elektrode gezogen werden soll, aber auf beiden Seiten im gleichen Abstand feststehende Gegenelektroden vorfindet, wird sich mehr oder weniger zufällig in die eine oder andere Richtung bewegen. Um eine Vorzugsrichtung zu definieren, ist demzufolge eine Asymmetrie erwünscht, die durch unterschiedliche Spaltbreiten auf beiden Seiten des beweglichen Elementes erreicht werden kann. Mit einer nachträglichen Einstellung bzw. Veränderung der Spaltbreite lässt sich eine derartige Struktur dennoch zunächst mit der aus technologischer Sicht günstigen gleichen Grabenbreite erzeugen.

### Stand der Technik

Zur nachträglichen dauerhaften Einstellung einer gegenüber dem Herstellungsprozess veränderten Spaltbreite zwischen einem beweglichen und einem feststehenden Strukturelement in einem mikromechanischen Bauelement sind bereits unterschiedliche Lösungen bekannt. So schlägt die DE 102004058103 B4 eine Methode vor, bei der das mit dem beweglichen Strukturelement verbundene Federelement mit einer Vorspannung versehen wird, die das bewegliche Strukturelement nach der Herstellung der Strukturen des mikromechanischen Bauelementes in die gewünschte neue Ruhelage bringt. Hierdurch kann die Spaltbreite zwischen diesem und einem feststehenden Gegenelement gegenüber dem Herstellungsprozess der Strukturen gezielt verringert werden.

M. Nowack et al., "Novel Post-Process Gap Reduction Technology of High Aspect Ratio Microstructures Utilizing Microwelding", Sensors and Actuators A: http://dx.doi.org/10.1016/j.sna.2011.12.026, zeigen eine andere Methode, bei der das bewegliche Strukturelement über das Federelement mit einer zunächst beweglichen Ankerstruktur verbunden ist. Das bewegliche Strukturelement wird dann über eine elektrostatische Kraft näher an das feststehende Gegenelement bewegt, um den gewünschten Spaltabstand einzustellen. In dieser Position wird die Ankerstruktur durch Mikroschweißen an einer geeignet angeordneten feststehenden Struktur fixiert.

Die US 2006/0054983 A1, die WO 2012/020132 A1 und die US 6211599 B1 zeigen Methoden, bei dem das bewegliche Strukturelement nach der Herstellung durch mechanische Zustellung näher an die feststehende Struktur gebracht und in dieser Position mit einem Ratschenmechanismus oder über eine bistabile Ausbildung der Zustellstruktur fixiert wird.

Die DE 10 2008 040 854 A1 offenbart ein Verfahren zur Vergrößerung einer Arbeitsspaltbreite in einer mikromechanischen Struktur, um vergleichsweise große Arbeitsamplituden zu ermöglichen. Die mikromechanische Struktur weist zwei mäanderförmige Spalte auf, die zwischen inneren, feststehenden Strukturabschnitten und äußeren beweglichen Strukturabschnitten liegen. Zum Verbreitern von Spaltabschnitten wird ein elektrisches Feld erzeugt, durch die die feststehenden Strukturabschnitte aufeinander zu bewegt werden. Zusätzlich oder alternativ kann ein federkraftunterstützter Verstellmechanismus realisiert werden.

Die DE 10 2010 002 545 A1 befasst sich mit der Fixierung einen kompletten Sensorchips auf einem Substrat, der elektrisch kontaktiert und mit einem Dichtungselement abgedichtet werden muss. Die aufgrund der unterschiedlichen thermischen Ausdehnungskoeffizienten des Substrats, des Sensorchips und des Dichtungselements auftretenden Belastungen am Sensorchip und die hierdurch verursachten Erfassungsfehler sollen dabei minimiert werden.

Die US 2007/0230241 offenbart ein Verfahren zur Fixierung zweier Komponente eines mikromechanischen Bauelements.

Bei den Varianten mit Ratschenmechanismus, bistabilen Zustellstrukturen sowie beim Einsatz mechanischer Vorspannungen müssen spezielle zusätzliche Strukturen eingeführt werden, die zusätzlich Fläche verbrauchen. Berücksichtigt man den Trend und die wirtschaftliche Forderung nach immer kleineren Sensoren, so sind diese Methoden langfristig nicht zielführend. Demgegenüber ist der zusätzliche Flächenverbrauch beim Einsatz des lokalen Mikroschweißens vergleichsweise gering. Allerdings werden für eine möglichst parallele Zustellbewegung mindestens vier Pads für das Aufsetzen von Sondennadeln zur elektrischen Initiierung des Schweißvorganges sowie entsprechende Anschlagstrukturen benötigt. Da für eine Vielzahl von Sensoren differentielle Signale ausgewertet werden, d. h. bei Auslenkung einer Sensormasse wird ein sich vergrößerndes Signal mit einem sich verkleinernden Signal verglichen, verdoppelt sich die Anzahl an Zustellstrukturen zusätzlich. Weiterhin muss bei dieser Methode davon ausgegangen werden, dass auch bei Vierfachaufhängung keine ideale Parallelführung in der Ebene zuverlässig möglich ist, da die lokalen Schweißverbindungen unterschiedlich ausgebildet sein können. Dies führt zu unterschiedlichen Breiten der Arbeitsspalte oder auch zu einer Strukturdrehung oder internen mechanischen Spannungen.

Ein weiterer Nachteil aller bisher bekannten Methoden zur nachträglichen Spalteinstellung und Strukturfixierung bei einer Anwendung auf Strukturen mit hohem Aspektverhältnis beruht darauf, dass die Strukturen in der Regel nicht ideal senkrecht in die Tiefe geätzt werden können. Wird bspw. bei einer 50 µm tiefen Struktur eine Abweichung des Ätzprofils von der Senkrechten von nur 0,1° zugelassen (Beispiel mit Aufweitung des Grabens in der Tiefe) und wird gegen eine feste Struktur gedrückt (Anschläge bzw. Stopper), welche die gleiche Abweichung von der Senkrechten, allerdings in negativer Richtung aufweist, dann ist das bewegliche Strukturelement bei einer Länge von 500 µm bestrebt, sich an den Anschlag bzw. Stopper anzulegen und somit zu verkippen. Dies kann zwar bei einer Vierfachaufhängung unterdrückt werden, allerdings wird dabei das gesamte Strukturelement einer internen Spannung ausgesetzt.

Die Aufgabe der vorliegenden Erfindung besteht darin, ein Verfahren zur nachträglichen Fixierung von zwei Komponenten eines mikromechanischen Bauelementes anzugeben, mit dem sich die Spaltbreite zwischen zwei Strukturelementen des Bauelementes nach der technologischen Herstellung der Strukturen mit geringem Aufwand dauerhaft neu einstellen lässt. Das Verfahren soll sich vor allem für mikromechanische Bauelemente einsetzen lassen, in denen sehr kleine Spaltbreiten bzw. Spalte mit einem sehr hohen Aspektverhältnis zwischen den beiden Strukturelementen erzeugt werden sollen.

### Darstellung der Erfindung

Die Aufgabe wird mit dem Verfahren gemäß Patentanspruch 1 gelöst. Die Patentansprüche 7 und 8 geben mikromechanische Bauelemente an, bei denen mindestens eine bewegliche Komponente gemäß dem vorgeschlagenen Verfahren an einer feststehenden oder ebenfalls beweglichen Komponente fixiert ist. Vorteilhafte Ausgestaltungen des Verfahrens sowie der mikromechanischen Bauelemente sind Gegenstand der abhängigen Patentansprüche oder lassen sich der nachfolgenden Beschreibung sowie den Ausführungsbeispielen entnehmen.

Bei dem vorgeschlagenen Verfahren wird eine erste bewegliche Komponente eines mikromechanischen Bauelementes an einer zweiten feststehenden oder beweglichen Komponente des Bauelementes fixiert, wobei sich eine Seitenfläche der ersten und eine Seitenfläche der zweiten Komponente gegenüberliegen. Hierzu wird bei der Fertigung des Bauelementes auf einer an die Seitenfläche angrenzenden Seite der ersten und/oder zweiten Komponente eine mit einem Schichtbereich über die Seitenfläche überstehende Schicht erzeugt. Die beiden Seitenflächen stoßen vorzugsweise bei der Fixierung aneinander. Dies ist aber nicht in jedem Fall erforderlich. Die angrenzenden Seiten stehen vorzugsweise jeweils im Wesentlichen senkrecht zu den Seitenflächen, wie dies bspw. beim Ätzen von Gräben mit hohem Aspektverhältnis in Siliziumsubstraten (deep silicon etch) erreicht wird. Unter der Fertigung des Bauelementes sind die Schritte zur Herstellung der Strukturen des Bauelementes, wie bspw. das Ätzen von Gräben oder die Aufbringung von Schichten zu verstehen. Die Begriffe "beweglich" oder "feststehend" beziehen sich jeweils auf den Grundkörper des Bauelementes, d.h. in der Regel auf das Substrat, in dem die Strukturen bzw. Komponenten des Bauelementes erzeugt wurden. Eine feststehende Komponente oder ein feststehendes Element ist daher starr mit diesem Grundköper verbunden.

Zur Fixierung der ersten beweglichen Komponente an der zweiten Komponente wird die erste Komponente so gegen die zweite Komponente bewegt, dass sich der an einer Komponente überstehende Schichtbereich über die an die Seitenfläche angrenzende Seite der anderen Komponente schiebt oder sich - im Falle einer überstehenden Schicht auf beiden Komponenten - beide überstehenden Schichten übereinander schieben. Aufgrund der Adhäsion der Grenzflächen haftet der überstehende Schichtbereich an der darunter liegenden Komponente oder die überstehenden Schichtbereiche aneinander. Die Haftkraft ist bei entsprechender Dimension des überstehenden Schichtbereichs so groß, dass diese Verbindung zwischen den beiden Komponenten für den gewünschten Einsatzzweck des mikromechanischen Bauelements als permanent angesehen werden kann. Die Haftkraft ist in der Regel deutlich höher als bei mikromechanischen Bauelementen auftretende Scherkräfte oder Kräfte, die ein Abheben und damit Lösen der aufliegenden Schicht gemeinsam mit der diese Schicht tragendem Komponente ermöglichen würden. Die überstehende Schicht kann dabei auch durch eine Schichtfolge von Schichten aus unterschiedlichen Materialien gebildet sein.

Grundsätzlich sind die Haftkräfte zwischen zwei Oberflächen verschiedener Körper umso größer, je näher sich die Oberflächen kommen können. So ist die Haftkraft besonders hoch bei geringer Oberflächenrauheit, beim Einsatz von weichem Material für zumindest eine der Oberflächen sowie bei einem flexiblen dünnen Körper, der sich an die Oberflächentopologie des anderen Körpers anpassen kann. Da bei dem vorliegenden Verfahren die Schichtunterseite üblicherweise eine vergleichbar geringe Rauheit aufweist wie das Bulkmaterial der Komponente, über die die Schicht geschoben wird, ist die Voraussetzung für eine sehr hohe Haftkraft gegeben. Außerdem ist es von Vorteil, dass sich dünnen Schichten durch ihre Elastizität der Oberfläche des Haftpartners anpassen können, so dass die effektive Kontaktfläche dadurch zusätzlich vergrößert wird.

Die Herstellung mikromechanischer Bauelemente erfolgt in der Regel durch geeignete Abscheide-, Maskierungs- und Ätzschritte, um die gewünschten feststehenden und freistehenden bzw. beweglichen Strukturen in einem Substrat zu erzeugen. Das Substrat und damit auch die beweglichen und feststehenden Komponenten oder Elemente können bspw. aus Silizium, Germanium, Siliziumkarbid oder Galliumarsenid bestehen. Auch andere Materialien sind selbstverständlich möglich. Die auf den zu verbindenden Komponenten aufgebrachte Schicht kann aus isolierendem Material, wie bspw. Siliziumdioxid oder Siliziumnitrid, aus leitfähigem Material, wie bspw. Aluminium, dotiertem Silizium oder Wolfram, oder auch aus einer Kombination von leitfähigen und nicht leitfähigen Materialien bestehen. Die Schichtmaterialien sind nicht auf die obigen Beispiele beschränkt.

Die bei der Fertigung des Bauelementes auf den Grundkörper bzw. das Substrat aufgebrachte Schicht wird so strukturiert, dass sie lediglich die gewünschte laterale Ausdehnung im Bereich über der jeweiligen Komponente aufweist, die erst anschließend durch lokales Ätzen des Substrates erzeugt wird. Durch Unterätzen dieser Schicht wird dann das Material der Komponente unterhalb der Schicht zusätzlich teilweise entfernt, bis der gewünschte Schichtüberstand erreicht ist. Selbstverständlich können auch andere Techniken zur teilweisen Entfernung des Substratmaterials unter der Schicht eingesetzt werden.

Vorzugsweise wird die überstehende Schicht mit einer Dicke von ≤ 2 µm und einem Überstand von ≤ 5 µm auf der Komponente erzeugt. Dies ergibt dann nach der Fixierung eine Überlappungsbreite der überstehenden Schicht mit der anderen Komponente oder der Schicht von ebenfalls ≤ 5 µm.

Die Zustellung zur Bewegung der beweglichen ersten Komponente gegen die feststehende oder bewegliche zweite Komponente kann mit unterschiedlichen Techniken erfolgen, vorzugsweise jedoch durch elektrostatische Kräfte. Hierzu müssen geeignete Elektroden an den Komponenten oder mit diesen verbundenen Elementen angeordnet sein. Dies ist jedoch bei vielen Anwendungen des vorgeschlagenen Verfahrens, insbesondere zur Einstellung der Spaltbreite zwischen Elektrodenstrukturen, bereits der Fall. Auch eine mechanische Zustellung ist möglich, bspw. durch äußere Anregung von mechanischen Schwingungen im mikromechanischen Bauelement.

In einer Weiterbildung des vorgeschlagenen Verfahrens wird die Stärke der Verbindung des überstehenden Schichtbereiches an der darunter liegenden Komponente oder zwischen den überstehenden Schichtbereichen durch eine äußere Energieeinwirkung weiter erhöht, die eine lokale Materialwanderung an der Verbindung bewirkt. So kann bspw. durch eine Temperung des Bauelementes eine Materialwanderung zwischen der Schicht und der Komponente, über die sie geschoben wurde, ausgelöst werden, durch die die Verbindungskraft bis zur chemischen Bindung (ionische Wechselwirkung) erhöht wird. Eine derartige Temperung, die häufig bereits Bestandteil des Herstellungsprozesses des mikromechanischen Bauelementes ist, erhöht somit die Verbindungsstärke zusätzlich. Eine Materialwanderung zwischen den in Kontakt stehenden Materialien zum Zwecke der Erhöhung der Verbindungskraft kann bspw. auch zu einer Legierungsbildung führen. Dies wird bspw. für den Fall einer Aluminiumschicht auf einem Siliziumkörper (heterogenes System) durch Erhitzung auf Temperaturen ab ca. 400° C erreicht, bei der das Silizium in das Aluminium wandert. Auch Interdiffusions- und Elektromigrationseffekte führen sowohl bei heterogenen als auch bei homogenen Materialkombinationen zu Materialwanderungen, welche die Haftkraft deutlich erhöhen. Für die Elektromigration muss ein elektrischer Strom durch die Grenzfläche zwischen den in Kontakt stehenden Partnern fließen. Für eine elektrisch isolierende Schicht kann zusätzlich zwischen den beiden Partnern auch ein elektrisch induziertes lokales Mikroschweißen von Substratmaterial durchgeführt werden. Dabei muss gewährleistet sein, dass durch das Substratmaterial, d.h. das Material der entsprechenden Komponente, ein ausreichend hoher Strom fließt. Vorteilhaft ist hier gegenüber dem Stand der Technik, dass die ehemals bewegliche Komponente bereits durch die überlappende Schicht fixiert wird und somit eine Lageänderung beim Verschweißen weitgehend ausgeschlossen wird. Ähnlich dem elektrisch induzierten lokalen Mikroschweißen von Substratmaterial kann auch das Laserschweißen eingesetzt werden. Da die zu verbindenden Partner durch die Haftkraft bereits fixiert sind, kann ein Laserstrahl mit relativ hoher Geschwindigkeit ein Verschmelzen der unterschiedlichen Bereiche der Schicht miteinander und/oder mit dem Substratmaterial bzw. Material der Komponente bewirken.

In einer vorteilhaften Ausgestaltung wird das vorgeschlagene Verfahren dazu genutzt, einen gewünschten Spaltabstand zwischen einem beweglichen Strukturelement und einem feststehenden Strukturelement nachträglich einzustellen. Unter dem Spaltabstand ist hierbei der Spaltabstand in der Ruhelage des beweglichen Strukturelementes zu verstehen, das über eine oder mehrere elastische Verbindungen, beispielsweise über ein oder mehrere Federelemente, in dem mikromechanischen Bauelement aufgehängt ist. Beide über den Spalt voneinander beabstandeten Strukturelemente können beispielsweise Elektrodenflächen tragen oder bilden, so dass eine variable Kapazität erhalten wird. Das bewegliche Strukturelement ist hierbei über die elastischen Verbindungen mit der beweglichen ersten Komponente verbunden, die gemäß dem vorgeschlagenen Verfahren an einer feststehenden zweiten Komponente fixiert wird. Die feststehende zweite Komponente kann Teil des Grundkörpers des mikromechanischen Bauelementes sein oder ist starr mit diesem verbunden. Bei der feststehenden zweiten Komponente kann es sich auch um das zweite Strukturelement handeln, das fest mit dem Grundkörper verbunden ist. Die bewegliche erste Komponente wird beispielsweise über elektrostatische Kräfte nach der Herstellung so bewegt bzw. zugestellt, dass der gewünschte Spaltabstand zwischen dem beweglichen Strukturelement und dem feststehenden Strukturelement erhalten wird. Die feststehende zweite Komponente und die bewegliche erste Komponente werden bei der Herstellung des Bauelementes so dimensioniert und angeordnet, dass diese beiden aneinander zu fixierenden Komponenten bei diesem gewünschten Spaltabstand gerade aneinander stoßen und sich dabei der an einer der Komponenten überstehende Schichtbereich über die andere Komponente schiebt oder - bei überstehenden Schichten an beiden Komponenten - sich beide überstehenden Schichtbereiche übereinander schieben und damit beide Komponenten aneinander fixiert sind. Auf diese Weise wird der Spaltabstand zwischen den Strukturelementen nach der Herstellung der Strukturen durch diese Zustellung und Fixierung geändert bzw. eingestellt, insbesondere verkleinert.

In gleicher Weise kann der Spaltabstand auch in einem Fall nachträglich geändert werden, in dem das bewegliche Strukturelement über einen oder mehrere elastische Verbindungselemente, insbesondere Federelemente, am Grundkörper befestigt ist. Das später feststehende Strukturelement ist dann starr mit der beweglichen Komponente verbunden, die entsprechend an einer feststehenden Komponente fixiert wird.

In einer weiteren Ausgestaltung wird mit dem vorgeschlagenen Verfahren der Spaltabstand zwischen einem ersten beweglichen Strukturelement und zwei weiteren feststehenden Strukturelementen eingestellt, die fest mit dem Grundkörper verbunden sind. Hierzu wird das erste bewegliche Strukturelement aus zwei Komponenten gebildet, die anschließend gemäß dem vorgeschlagenen Verfahren durch Überschieben der überstehenden Schicht(en) aneinander fixiert werden. Die beiden Komponenten können dabei beispielsweise nach dem Zusammenfügen die beiden feststehenden Strukturelemente in einer Ebene rahmenartig umschließen. Durch das Zusammenfügen wird der Spalt zwischen beiden Hälften des ersten Strukturelementes und dem jeweils gegenüberliegenden festen Strukturelement durch die Verbindung verkleinert. Beide Hälften sind dabei jeweils über Federelemente gelagert, so dass die Bewegungsfähigkeit auch nach der Verbindung der beiden Hälften erhalten bleibt. Die feststehenden Strukturelemente können auch an anderer Stelle angeordnet sein, beispielsweise beidseitig des beweglichen Strukturelementes.

Das vorgeschlagene Verfahren ermöglicht damit, Einzelstrukturen bzw. Elemente eines mikromechanischen Bauelementes während des technologischen Herstellungsprozesses mit Spaltbreiten zu erzeugen, die auf den Fabrikationsprozess optimiert sind. Die für die Funktion gewünschte Arbeitsspaltbreite wird dann erst nachträglich eingestellt. Das Verfahren benötigt zur Verbindung der Strukturen keine zusätzlichen Komponenten wie bei Ratschenanordnungen oder bistabilen Zustellstrukturen. Es können auch zwei bewegliche Komponenten miteinander verbunden werden, die nicht ohne weiteres eine Sektorierung für die Erzeugung definierter Schweißpunkte zum Mikroschweißen zulassen. Durch die Verbindung an der Oberfläche können signifikante Kraftkomponenten in den verbundenen Komponenten senkrecht zur Oberfläche vermieden werden, wie sie beispielsweise bedingt durch von 90° abweichende Böschungswinkel bei anderen Lösungen auftreten können.

Eine Ausgestaltung eines mit dem Verfahren erhaltenen mikromechanischen Bauelementes weist damit zwei Komponenten auf, die durch eine Schicht dauerhaft und bestimmungsgemäß aneinander fixiert sind, wobei sich zwei Seitenflächen der beiden Komponenten gegenüber liegen. Die Schicht ist dabei in einer Ausgestaltung auf einer an die Seitenfläche der beiden Komponenten angrenzenden Seite einer der Komponenten ausgebildet, steht über die Seitenfläche über und ist mit dem überstehenden Schichtbereich über die an die Seitenfläche angrenzende Seite der anderen Komponente geschoben. Unter der dauerhaften und bestimmungsgemäßen Fixierung wird dabei verstanden, dass die beiden Komponenten für den bestimmungsgemäßen Einsatz des Bauelements aneinander fixiert bleiben. Die beiden Komponenten sind dabei nur durch den überstehenden Schichtbereich aneinander fixiert. In einer anderen Ausgestaltung weisen beide Komponenten auf einer Seite entsprechende überstehende Schichtbereiche auf, die bei der Fixierung übereinander geschoben sind. An einer oder beiden Komponenten können dabei zusätzliche bewegliche Strukturelemente über elastische Verbindungen, beispielsweise Federn, befestigt sein.

Bei einer weiteren Ausgestaltung weist das mikromechanische Bauelement ein bewegliches Strukturelement auf, das aus zwei Komponenten zusammengesetzt ist, wobei sich eine Seitenfläche der ersten und eine Seitenfläche der zweiten Komponente gegenüberliegen. Beide Komponenten sind dabei über eine Schicht gemäß dem vorgeschlagenen Verfahren aneinander fixiert. Die Schicht kann dabei an der einen oder der anderen Komponente auf der an die Seitenfläche angrenzenden Seite aufgebracht sein, steht über die Seitenfläche über und ist mit dem überstehenden Schichtbereich über die andere Komponente geschoben. Auch beide Komponenten können eine entsprechende überstehende Schicht tragen, wobei dann die Fixierung durch Überschieben des einen über den anderen überstehenden Schichtbereich erfolgt.

In einer anderen Ausgestaltung ist eine der beiden über die Schicht aneinander fixierten Komponenten starr mit dem Grundkörper des Bauelementes verbunden. Die andere Komponente ist über eine oder mehrere elastische Verbindungen mit einem ersten Strukturelement verbunden, das in der Ruhelage von einem zweiten Strukturelement durch einen Spalt beabstandet ist. Das zweite Strukturelement kann dabei starr oder über eine oder mehrere zweite elastische Verbindungen mit dem Grundkörper verbunden sein.

Bei einer weiteren Ausgestaltung eines mikromechanischen Bauelementes ist ebenfalls eine der beiden über die Schicht aneinander fixierten Komponenten starr mit dem Grundkörper des Bauelementes verbunden. Ein erstes Strukturelement ist starr mit der anderen Komponente verbunden. Ein zweites Strukturelement ist über eine oder mehrere elastische Verbindungen mit dem Grundkörper des Bauelements verbunden, wobei zwischen dem ersten und dem zweiten Strukturelement in Ruhelage des zweiten Strukturelements ein definierter Spalt vorhanden ist.

Die vorgeschlagenen mikromechanischen Bauelemente tragen vorzugsweise an geeigneter Stelle Elektrodenflächen, so dass sie als mikroelektromechanische Bauelemente beispielsweise für Sensor- oder Aktoranwendungen ausgebildet sein können. So lassen sich mit dem vorgeschlagenen Verfahren mikroelektromechanische Bauelemente mit definierten Spaltbreiten bereitstellen, die als hochgenaue Beschleunigungssensoren, als Neigungssensoren, als Gyroskope, als Vibrationssensoren oder auch als MEMS-Schalter (HF-Schalter) oder variable MEMS-Kondensatoren, beispielsweise für HF-Anwendungen, ausgebildet sein können. Bei einem kapazitiven mikromechanischen Bauelement lässt sich das Verfahren für Bauformen mit elektrodenabstandsabhängiger aber auch flächenabhängiger Charakteristik einsetzen.

### Kurze Beschreibung der Zeichnungen

Das vorgeschlagene Verfahren und die vorgeschlagenen mikromechanischen Bauelemente werden nachfolgend anhand von Ausführungsbeispielen in Verbindung mit den Zeichnungen nochmals näher erläutert. Hierbei zeigen:
- Fig. 1: eine schematische Darstellung einer Struktur mit kapazitivem Wandlerprinzip gemäß dem Stand der Technik;
- Fig. 2: eine schematische Darstellung des vorgeschlagenen Verfahrens in Seitenansicht;
- Fig. 3: die gemäß Figur 2 aneinander fixierten Komponenten in Draufsicht;
- Fig. 4: ein Beispiel für Strukturen eines mikromechanischen Bauelementes gemäß der vorgeschlagenen Erfindung;
- Fig. 5: eine Darstellung zur Veranschaulichung einer weiteren Ausgestaltung des vorgeschlagenen Verfahrens;
- Fig. 6: ein weiteres Beispiel für Strukturen eines mikromechanischen Bauelementes gemäß der vorgeschlagenen Erfindung vor und nach der Fixierung der Komponenten;
- Fig. 7: ein Beispiel für eine Fixierung an hintereinander gestaffelten Komponenten; und
- Fig. 8: ein weiteres Beispiel für Strukturen eines mikromechanischen Bauelementes gemäß der vorgeschlagenen Erfindung.

### Wege zur Ausführung der Erfindung

Die Struktur mit kapazitivem Wandlerprinzip der Fig. 1 gemäß dem Stand der Technik wurde bereits in der Beschreibungseinleitung erläutert. Fig. 2 zeigt eine schematische Darstellung der Fixierung einer beweglichen Komponente 4 an einer feststehenden Komponente 5 gemäß dem erfindungsgemäßen Verfahren. Die bewegliche Komponente 4 ist dabei über ein Federelement 8 an einer Ankerstruktur 7 befestigt, die fest mit dem nicht dargestellten Grundkörper des mikromechanischen Bauelements verbunden ist. Die feststehende Komponente 5 ist ebenfalls fest mit dem Grundkörper des mikromechanischen Bauelementes, beispielsweise einem Siliziumsubstrat, verbunden. Der Spalt 3 zwischen den sich gegenüberliegenden Seitenflächen der beiden Komponenten 4, 5 wird durch Bewegung der ersten Komponente 4 gegen die zweite Komponente 5 geschlossen. Auf der ersten Komponente 4 ist hierbei eine Schicht 10 auf der im Wesentlichen senkrecht zur Seitenfläche angrenzenden Seite aufgebracht, die mit einem Schichtbereich über die Seitenfläche übersteht. Bei Bewegung der beweglichen Komponente 4 gegen die feststehende Komponente 5 wird diese Schicht 10 mit dem überstehenden Schichtbereich über die feststehende Komponente 5 geschoben, wie dies im rechten Teil der Figur dargestellt ist. Dadurch treten hohe Adhäsionskräfte zwischen dem überstehenden Schichtbereich und der zweiten Komponente 5 auf, die zur Fixierung der beiden Komponenten 4, 5 aneinander dient. Die Haftkraft ist dabei deutlich höher als Scherkräfte oder andere Kräfte, die bei typischen mikromechanischen Bauelementen auftreten und ein Abheben und damit ein Lösen der aufliegenden Schicht gemeinsam mit der diese Schicht tragenden Komponente ermöglichen würden.

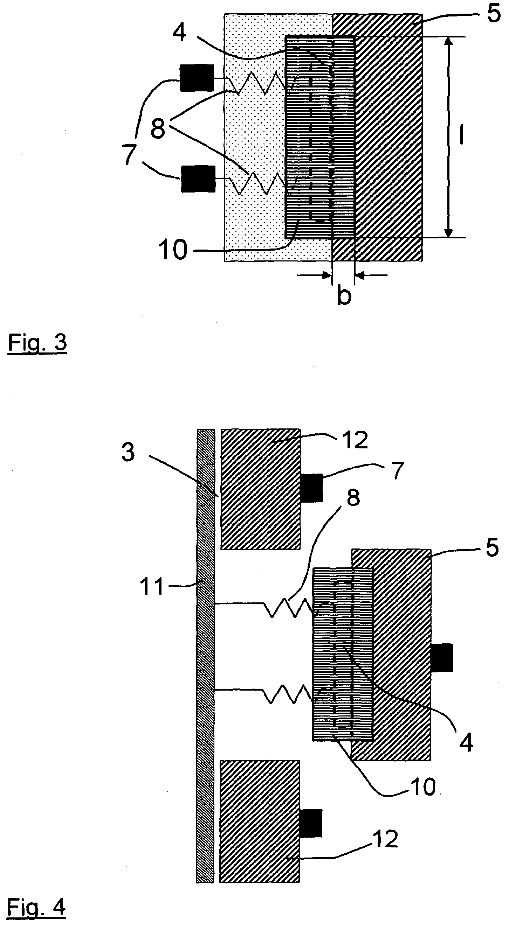

Überraschenderweise konnte für eine typische Sensoranordnung mit einer mit der fixierten Komponente 4 verbundenen beweglichen Masse von ca. 50 *µ*g beobachtet werden, dass die Haftkraft um ein Vielfaches höher ist als die Gewichtskraft der beweglichen Masse, auch wenn bei einer Überlappungslänge 1 von ca. 400 *µ*m der Überstand (Überlappungsbreite b) der Schicht 10 über der feststehenden Komponente 5 nur 1 *µ*m beträgt. Die Überlappungslänge 1 entspricht in diesem Fall der Länge der nachträglich fixierten Komponente 4 zuzüglich dem Doppelten der Überlappungsbreite b, vorausgesetzt, diese wurde durch Unterätzung des Substratmaterials erzeugt. Fig. 3 zeigt hierzu eine Draufsicht auf die aneinander fixierten Komponenten des rechten Teils der Figur 2. Die Überlappungslänge 1 und die Überlappungsbreite b sind in dieser Figur erkennbar.

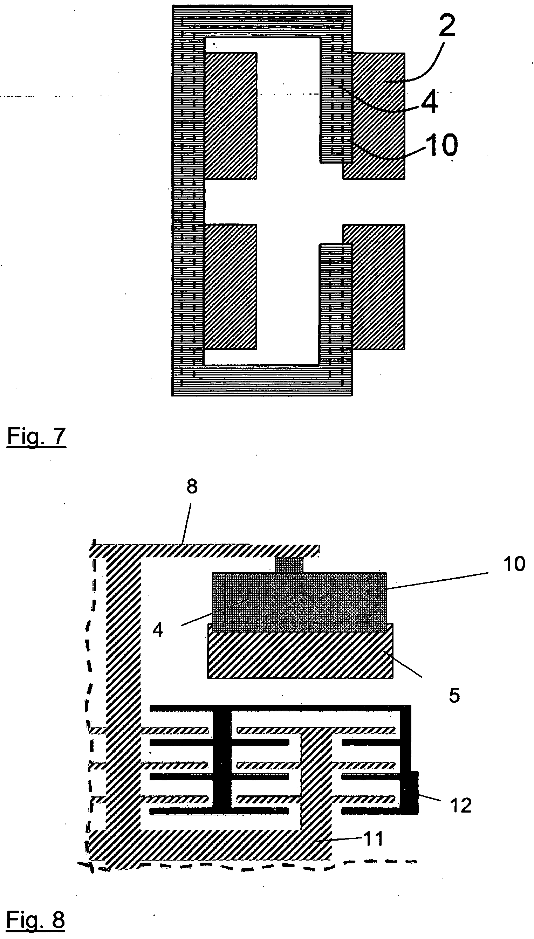

Diese Fixierung lässt sich nutzen, um die Spaltbreite zwischen einem beweglichen Element und einem feststehenden Element oder zwischen zwei beweglich gelagerten Elementen in einem mikromechanischen Bauelement nachträglich einzustellen und bezüglich der Ruhelage zu fixieren. Die einzelnen Strukturen müssen selbstverständlich hierzu vorab geeignet dimensioniert und angeordnet werden, um anschließend die gewünschte Spaltbreite zu erhalten. Fig. 4 zeigt hierzu ein Beispiel, bei dem an der ursprünglich beweglichen ersten Komponente 4 (vgl. Figuren 2 oder 3) ein Strukturelement 11, beispielsweise in Funktion einer Elektrode, über Federelemente 8 befestigt ist. Nach der Fixierung der ersten Komponente 4 bleibt dieses Strukturelement 11 über die Federn 8 beweglich. Damit lässt sich nachträglich zwischen diesem ersten Strukturelement 11 und einem zweiten Strukturelement 12 des Bauteils ein gegenüber dem Herstellungszustand veränderter Arbeitsspalt einstellen. Fig. 4 zeigt hierzu das zweite Strukturelement 12, das ebenso wie die zweite Komponente 5 fest mit dem Grundkörper des Bauelements verbunden ist. Da die Fixierung der ersten Komponente 4 an der zweiten Komponente 5 durch Bewegung bzw. Zustellung der ersten Komponente 4 erfolgt, verringert sich die Spaltbreite des Spaltes 3 zwischen dem ersten Strukturelement 11 und dem zweiten Strukturelement 12 entsprechend. Nach der Fixierung wird somit eine gegenüber dem Herstellungszustand verringerte Spaltbreite des Arbeitsspaltes 3 erhalten. Das zweite Strukturelement 12 kann hierbei ebenfalls Elektroden tragen, um dadurch einen kapazitiven Wandler zu erhalten. Durch äußere Krafteinwirkung kann sich das erste Strukturelement 11 um die Ruhelage herum bewegen und im Fall des dargestellten, hier verkleinerten Arbeitsspaltes 3 unter Nutzung des kapazitiven Wandlerprinzips sehr hohe Kapazitätsänderungen erzeugen. Dabei können die Strukturelemente als planparallele Elektroden ausgeführt sein oder auch als ineinander greifende kamm- oder fingerartige Strukturen, wie dies in der Figur 8 anhand eines anderen Beispiels dargestellt ist.

Bei einer anderen möglichen Variante ist das erste Strukturelement 11 fest mit der ersten Komponente 4 verbunden. Dafür ist das zweite Strukturelement 12 über eine bzw. mehrere Federn beweglich am Grundkörper oder einem weiteren mit dem Grundkörper fest verbundenen Element verankert.

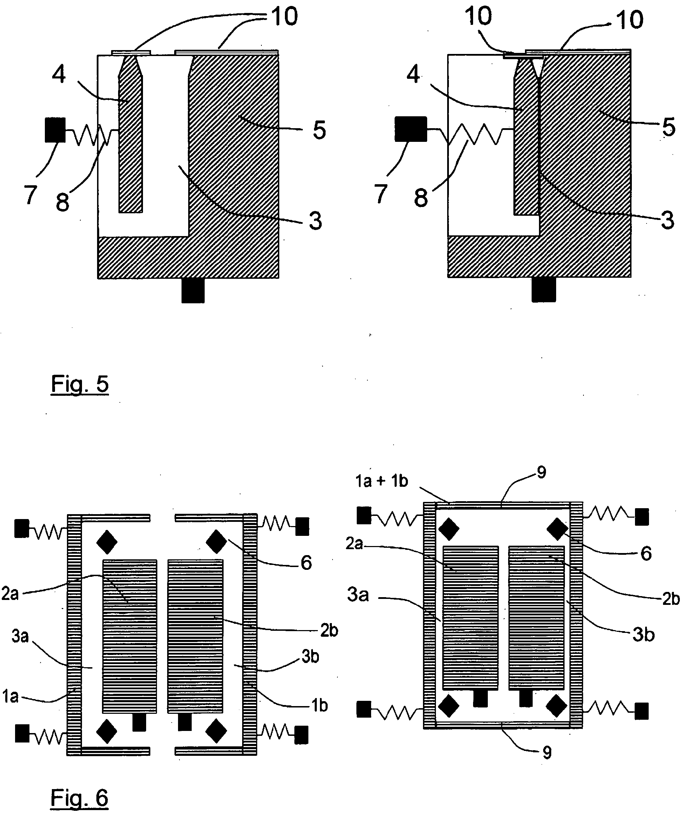

Ein weiteres Beispiel des vorgeschlagenen Verfahrens sowie einer damit erhaltenen Ausgestaltung eines mikromechanischen Bauelements ist in Fig. 5 in Seitenansicht schematisch dargestellt. Bei dieser Darstellung weisen gegenüber der Fig. 2 sowohl die erste Komponente 4 als auch die zweite Komponente 5 eine entsprechende überstehende Schicht 10 auf. Durch Bewegung der beweglichen Komponente 4 gegen die feststehende Komponente 5 schiebt sich ein Teil der Schicht 10 über oder unter den überstehenden Schichtbereich der feststehenden Komponente 5 und führt dadurch zur Fixierung durch Adhäsion der beiden Schichten aneinander. Die beiden Komponenten müssen dabei entsprechend geformt sein, hier im oberen Bereich verjüngt, um den gewünschten Schichtüberlapp bei einem Kontakt der beiden Komponenten zu ermöglichen. Da die Dicke der Schicht 10 z.B. nur 100 nm betragen kann und die Bauhöhe der beweglichen Komponente 4 50 *µ*m und mehr, wird ersichtlich, dass die durch die Überlappung der Schichten verursachte Strukturverschiebung nach oben oder unten (also < 0,2 % der Strukturhöhe) für die Anwendung in der Regel unerheblich ist.

Die Ausgestaltung der Fig. 5 hat den Vorteil, dass die strukturierte Schicht 10 so auf der Oberfläche des Ausgangssubstrates erzeugt werden kann, dass die Gräben zwischen den unterschiedlichen Komponenten des Bauelements anschließend unter Nutzung dieser strukturierten Schicht als Ätzmaske geätzt werden können. Dies erlaubt eine einfache Herstellung der Strukturen des Bauelementes mit den für die Fixierung erforderlichen überstehenden Schichten. Die beiden Schichten über den beiden Komponenten haben hierbei identischen Überhang.

Neben der überraschend hohen Adhäsionskraft an der Überlappungsstelle zwischen der Schicht 10 und der Oberfläche der Komponente bzw. zwischen den beiden Schichten 10 kann die Festigkeit der mechanischen Verbindung zusätzlich verbessert werden, indem eine Materialdiffusion und/oder Legierungsbildung an der Überlappungsstelle durch thermische Behandlung und/oder elektrischen Strom oder elektrisch induziertes Mikroschweißen oder Laserschweißen ausgelöst wird. Dies gilt für alle hier vorgeschlagenen Ausgestaltungen.

Fig. 6 zeigt ein weiteres Beispiel einer Struktur eines mikromechanischen Bauelementes gemäß der vorliegenden Erfindung, wobei im linken Teil die Verhältnisse vor der Zustellung und Fixierung und im rechten Teil die Verhältnisse nach der Fixierung dargestellt sind. So zeigt die Figur zwei feststehende Elektrodenstrukturen 2a, 2b, die fest mit dem Grundkörper verbunden sind. Zwei bewegliche Teilkomponenten 1a, 1b sind über Federn 8 am Grundkörper oder einer fest mit dem Grundkörper verbundenen Struktur aufgehängt. Die beiden beweglichen Teilkomponenten 1a, 1b werden anschließend gegeneinander bewegt und durch Schichtüberhang gemäß dem hier vorgeschlagenen Verfahren aneinander fixiert. Dies ist im rechten Teil der Figur schematisch dargestellt. Die zur Fixierung genutzten Schichten sind in dieser Darstellung nicht ersichtlich. Die Fixierung erfolgt hier an zwei getrennten Verbindungsstellen 9. Wie aus dem rechten Teil der Figur hervorgeht, werden somit die beiden separat beweglichen Teilkomponenten 1a, 1b zu einem einzigen beweglichen Strukturelement zusammengefügt, das nach dem Verbinden der beweglichen Teilkomponenten über die Federelemente 8 beweglich bleibt. Der Spalt zwischen den beweglichen Teilkomponenten 1a, 1b und den feststehenden Elektrodenstrukturen 2a, 2b wurde durch diesen Prozess nachträglich verkleinert, wie aus dem Vergleich des linken und rechten Teils der Figur deutlich zu erkennen ist. Die ebenfalls dargestellten Anschlagstrukturen 6 dienen lediglich dazu, den Kontakt der durch das bewegliche Strukturelement realisierten Elektrode mit den als Gegenelektrode dienenden Elektrodenstrukturen 2a, 2b zu verhindern.

Eine besonders stabile Verbindung wird erreicht, indem nicht nur die Überlappungslänge und -breite der Schicht 10 zwischen den beiden Komponenten 4, 5 möglichst groß gestaltet wird, sondern eine Überlappung der Schicht 10 an mehreren hintereinander gestaffelten Komponenten erreicht wird. Dies ist in der Fig. 7 schematisch angedeutet, die hintereinander gestaffelte zweite Komponenten 5 und entsprechend gestaffelte Bereiche der beweglichen Komponente 4 zeigt.

Fig. 8 zeigt schließlich noch eine weitere Ausgestaltung, bei der die über einen Spalt beabstandeten ersten und zweiten Strukturelemente 11, 12 als Kammelektroden ausgebildet sind. Das erste Strukturelement 11 ist hierbei wiederum über eine elastische Federverbindung 8 mit einer ersten Komponente 4 verbunden, die gemäß dem vorliegenden Verfahren durch Schichtüberlapp an einer feststehenden zweiten Komponente 5 fixiert ist.

Die vorliegende Erfindung ist selbstverständlich nicht auf die in den Beispielen dargestellten Geometrien der ersten und zweiten Komponente bzw. ersten und zweiten Strukturelemente beschränkt. Dem Fachmann ist ersichtlich, dass viele unterschiedliche Geometrien der einzelnen Elemente genutzt werden können, um eine nachträgliche Spalteinstellung zwischen zwei Strukturelementen des Bauelements in der gewünschten Weise zu erreichen. Die in dieser Anmeldung verwendeten Begriffe der Komponente und des Strukturelementes dienen lediglich zur Unterscheidung einzelner Elemente oder Bereiche des Bauelementes. Grundsätzlich besteht kein Unterschied zwischen einer Komponente und einem Strukturelement.

### Bezugszeichenliste

- 1: erstes Strukturelement bzw. Elektrode
- 1a, b: bewegliche Teilkomponenten
- 2: zweites Strukturelement bzw. Elektrode
- 2a,b: feststehende Elektrodenstrukturen
- 3: Spalt zwischen den Strukturelementen
- 4: erste Komponente
- 5: zweite Komponente
- 6: Anschlag
- 7: Ankerstruktur
- 8: Federelement
- 9: Verbindungsstellen zwischen den beweglichen Komponenten
- 10: Schicht
- 11: erstes Strukturelement
- 12: zweites Strukturelement

## Patentansprüche

1. Verfahren zur Fixierung einer beweglichen ersten Komponente (4) eines mikromechanischen Bauelementes an einer feststehenden oder beweglichen zweiten Komponente (5) des Bauelementes, wobei sich eine Seitenfläche der ersten und eine Seitenfläche der zweiten Komponente gegenüberliegen, bei dem
- bei der Fertigung des Bauelementes auf einer an die Seitenfläche angrenzenden Seite der ersten und/oder zweiten Komponente (4, 5) eine mit einem Schichtbereich über die Seitenfläche überstehende Schicht (10) erzeugt wird, und
- die erste Komponente (4) zur Fixierung so gegen die zweite Komponente bewegt wird, dass sich der überstehende Schichtbereich über die an die Seitenfläche angrenzende Seite der ersten oder zweiten Komponente (4, 5) schiebt oder sich, im Falle einer bei beiden Komponenten (4, 5) vorhandenen überstehenden Schicht (10), die überstehenden Schichtbereiche übereinander schieben, so dass aufgrund von Adhäsion der überstehende Schichtbereich an der darunter liegenden Komponente (4, 5) oder die überstehenden Schichtbereiche aneinander haften.

2. Verfahren nach Anspruch 1 zur Einstellung eines vorgebbaren Spaltabstandes zwischen zwei Strukturelementen (11, 12) des mikromechanischen Bauelements, bei dem
- die zweite Komponente (5) starr mit einem Grundkörper des Bauelements verbunden ist,
- ein erstes (11) der beiden Strukturelemente über eine oder mehrere erste elastische Verbindungen (8) mit der beweglichen ersten Komponente (4) verbunden ist,
- ein zweites (12) der beiden Strukturelemente starr oder über eine oder mehrere zweite elastische Verbindungen (8) mit dem Grundkörper verbunden ist, und
- die zweite Komponente (5) und die bewegliche erste Komponente (4) bei der Fertigung des Bauelementes so ausgebildet und angeordnet werden, dass durch die Fixierung der beweglichen ersten Komponente (4) an der zweiten Komponente (5) der vorgegebene Spaltabstand zwischen den beiden Strukturelementen (11, 12) erhalten wird.

3. Verfahren nach Anspruch 1 zur Einstellung eines vorgebbaren Spaltabstandes zwischen zwei Strukturelementen (11, 12) des mikromechanischen Bauelements, bei dem
- die zweite Komponente (5) starr mit einem Grundkörper des Bauelements verbunden ist,
- ein erstes (11) der beiden Strukturelemente starr mit der beweglichen ersten Komponente (4) verbunden ist, und
- ein zweites (12) der beiden Strukturelemente über eine oder mehrere erste elastische Verbindungen (8) mit dem Grundkörper verbunden ist,
- die zweite Komponente (5) und die bewegliche erste Komponente (4) bei der Fertigung des Bauelementes so ausgebildet und angeordnet werden, dass nach der Fixierung der beweglichen ersten Komponente (4) an der zweiten Komponente (5) der vorgegebene Spaltabstand zwischen den beiden Strukturelementen (11, 12) erhalten wird.

4. Verfahren nach Anspruch 1 zur Einstellung eines vorgebbaren Spaltabstandes zwischen einem beweglichen und zwei fest angeordneten Strukturelementen (2a, 2b) des mikromechanischen Bauelements, bei dem
- das bewegliche Strukturelement zunächst aus zwei gegeneinander beweglichen Hälften (1a, 1b) hergestellt wird, die durch die bewegliche erste Komponente (4) und die zweite Komponente (5) gebildet werden,
- die beiden fest angeordneten Strukturelemente (2a, 2b) starr mit einem Grundkörper des Bauelements verbunden und jeweils in einem Abstand zu den zwei gegeneinander beweglichen Hälften (1a, 1b) des beweglichen Strukturelementes angeordnet sind, und
- die bewegliche erste Komponente (4) und die zweite Komponente (5) bei der Fertigung des Bauelementes so ausgebildet und angeordnet werden, dass nach der Fixierung der beweglichen ersten Komponente (4) an der zweiten Komponente (5) der vorgegebene Spaltabstand zwischen der beweglichen und den zwei fest angeordneten Strukturelementen (2a, 2b) erhalten wird.

5. Verfahren nach einem der Ansprüche 1 bis 4,
**dadurch gekennzeichnet,**
**dass** die überstehende Schicht (10) eine Dicke von ≤ 2 *µ*m aufweist und über eine Distanz von ≤ 5 *µ*m über die Seitenfläche übersteht.

6. Verfahren nach einem der Ansprüche 1 bis 5,
**dadurch gekennzeichnet,**
**dass** die Stärke der haftenden Verbindung des überstehenden Schichtbereiches an der darunter liegenden Komponente (4, 5) oder zwischen den überstehenden Schichtbereichen durch eine Energieeinwirkung erhöht wird, die eine lokale Materialwanderung an der Verbindung bewirkt.

7. Mikromechanisches Bauelement mit einer ersten Komponente (4), die beim bestimmungsgemäßen Einsatz des Bauelementes dauerhaft an einer feststehenden zweiten Komponente (5) des Bauelementes fixiert ist, wobei sich eine Seitenfläche der ersten und eine Seitenfläche der zweiten Komponente gegenüberliegen,
**dadurch gekennzeichnet,**
**dass** die erste Komponente (4) durch eine überstehende Schicht (10) an der zweiten Komponente (5) fixiert ist, die auf einer an die Seitenfläche angrenzenden Seite der ersten und/oder zweiten Komponente (4, 5) ausgebildet ist und mit einem Schichtbereich über die Seitenfläche übersteht,
wobei der überstehende Schichtbereich über die an die Seitenfläche angrenzende Seite der ersten und/oder zweiten Komponente (4, 5) geschoben ist oder, im Falle einer bei beiden Komponenten (4, 5) vorhandenen überstehenden Schicht (10), die überstehenden Schichtbereiche übereinander geschoben sind.

8. Mikromechanisches Bauelement mit einem beweglichen Strukturelement, das aus einer ersten und einer zweiten Teilkomponente (1a, 1b) zusammengesetzt ist, wobei sich eine Seitenfläche der ersten und eine Seitenfläche der zweiten Teilkomponente gegenüberliegen,
**dadurch gekennzeichnet,**
**dass** die erste Teilkomponente (1a) durch eine überstehende Schicht (10) an der zweiten Teilkomponente (1b) fixiert ist, die auf einer an die Seitenfläche angrenzenden Seite der ersten und/oder zweiten Teilkomponente (1a, 1b) ausgebildet ist und mit einem Schichtbereich über die Seitenfläche übersteht, wobei der überstehende Schichtbereich über die an die Seitenfläche angrenzende Seite der ersten und/oder zweiten Teilkomponente (1a, 1b) geschoben ist oder, im Falle einer bei beiden Teilkomponenten (1a, 1b) vorhandenen überstehenden Schicht (10), die überstehenden Schichtbereiche übereinander geschoben sind.

9. Bauelement nach Anspruch 7,
**dadurch gekennzeichnet, dass**
- die zweite Komponente (5) starr mit einem Grundkörper des Bauelements verbunden ist,
- ein erstes Strukturelement (11) über eine oder mehrere erste elastische Verbindungen (8) mit der ersten Komponente (4) verbunden ist, und
- ein zweites Strukturelement (12) starr oder über eine oder mehrere zweite elastische Verbindungen (8) mit dem Grundkörper verbunden ist,
- wobei erstes und zweites Strukturelement (11, 12) in einer Ruhelage durch einen Spalt (3) voneinander beabstandet sind.

10. Bauelement nach Anspruch 7,
**dadurch gekennzeichnet, dass**
- die zweite Komponente (5) starr mit einem Grundkörper des Bauelements verbunden ist,
- ein erstes Strukturelement (11) starr mit der ersten Komponente (4) verbunden ist,
- ein zweites Strukturelement (12) über eine oder mehrere erste elastische Verbindungen (8) mit dem Grundkörper verbunden ist, und
- wobei erstes und zweites Strukturelement (11, 12) in einer Ruhelage durch einen Spalt (3) voneinander beabstandet sind.

11. Bauelement nach einem der Ansprüche 7 bis 10,
**dadurch gekennzeichnet,**
**dass** die erste Komponente (4) oder erste Teilkomponente (1a) allein durch den überstehenden Schichtbereich an der zweiten Komponente (5) oder zweiten Teilkomponente (1b) fixiert ist.

12. Bauelement nach einem der Ansprüche 9 bis 11, **dadurch gekennzeichnet,**
**dass** das erste und zweite Strukturelement (11, 12) als Elektroden ausgebildet sind oder Elektroden tragen.

## Claims

1. A method for fixing a movable first component (4) of a micromechanical device on a stationary or movable second component (5) of the device, wherein a lateral surface of the first component and a lateral surface of the second component face one another, wherein
- a layer (10) protruding over the lateral surface with a layer area is produced during the manufacture of the device on a side of the first and/or second component (4, 5) adjoining the lateral surface, and
- the first component (4) is moved against the second component in order to be fixed such that the protruding layer area is pushed over the side of the first or second component (4, 5) adjoining the lateral surface or, if a protruding layer (10) is provided on both components (4, 5), the protruding layer areas are pushed on top of one another, and the protruding layer area adheres to the component (4, 5) lying thereunder or the protruding layer areas adhere to one another due to adhesion.

2. The method according to claim 1 for adjusting a predefined gap clearance between two structural elements (11, 12) of the micromechanical device, wherein
- the second component (5) is rigidly connected to a base body of the device,
- a first (11) of the two structural elements is connected to the movable first component (4) by means of one or more first elastic connections (8),
- a second (12) of the two structural elements is connected to the base body rigidly or by means of one or more second elastic connections (8), and
- the second component (5) and the movable first component (4) are during the manufacture of the device realized and arranged in such a way that the predefined gap clearance between the two structural elements (11, 12) is achieved by fixing the movable first component (4) on the second component (5).

3. The method according to claim 1 for adjusting a predefined gap clearance between two structural elements (11, 12) of the micromechanical device, wherein
- the second component (5) is rigidly connected to a base body of the device,
- a first (11) of the two structural elements is rigidly connected to the movable first component (4),
- a second (12) of the two structural elements is connected to the base body by means of one or more first elastic connections (8), and
- the second component (5) and the movable first component (4) are during the manufacture of the device realized and arranged in such a way that the predefined gap clearance between the two structural elements (11, 12) is achieved after the movable first component (4) is fixed on the second component (5).

4. The method according to claim 1 for adjusting a predefined gap clearance between a movable and two stationary structural elements (2a, 2b) of the micromechanical device, wherein
- the movable structural element is initially manufactured of two halves (1a, 1b) that can be moved relative to one another and are formed by the movable first component (4) and the second component (5),
- the two stationary structural elements (2a, 2b) are rigidly connected to a base body of the device and respectively arranged at a distance from the two halves (1a, 1b) of the movable structural element that can be moved relative to one another, and
- the movable first component (4) and the second component (5) are during the manufacture of the device realized and arranged in such a way that the predefined gap clearance between the movable and the two stationary structural elements (2a, 2b) is achieved after the movable first component (4) is fixed on the second component (5).

5. The method according to one of claims 1-4,
**characterized in**
**that** the protruding layer (10) has a thickness of ≤ 2 µm and protrudes over the lateral surface by a distance of ≤ 5 µm.

6. The method according to one of claims 1-5,
**characterized in**
**that** the strength of the adhesive connection of the protruding layer area on the component (4, 5) lying thereunder or between the protruding layer areas is increased by an energy action that causes a local material migration at the connection.

7. A micromechanical device with a first component (4), which during the intended use of the device is permanently fixed on a stationary second component (5) of the device, wherein a lateral surface of the first component and a lateral surface of the second component face one another,
**characterized in**
**that** the first component (4) is fixed on the second component (5) by means of a protruding layer (10) that is produced on a side of the first and/or second component (4, 5) adjoining the lateral surface and protrudes over the lateral surface with a layer area, wherein the protruding layer area is pushed over the side of the first and/or second component (4, 5) adjoining the lateral surface or, if a protruding layer (10) is provided on both components (4, 5), the protruding layer areas are pushed on top of one another.

8. A micromechanical device with a movable structural element that is composed of a first and a second subcomponent (1a, 1b), wherein a lateral surface of the first subcomponent and a lateral surface of the second subcomponent face one another,
**characterized in**
**that** the first subcomponent (1a) is fixed on the second subcomponent (1b) by means of a protruding layer (10), wherein said layer is produced on a side of the first and/or second subcomponent (1a, 1b) adjoining the lateral surface and protrudes over the lateral surface with a layer area,
wherein the protruding layer area is pushed over the side of the first and/or second subcomponent (1a, 1b) adjoining the lateral surface or, if a protruding layer (10) is provided on both subcomponents (1a, 1b), the protruding layer areas are pushed on top of one another.

9. The device according to claim 7,
**characterized in that**
- the second component (5) is rigidly connected to a base body of the device,
- a first structural element (11) is connected to the first component (4) by means of one or more first elastic connections (8), and
- a second structural element (12) is connected to the base body rigidly or by means of one or more second elastic connections (8),
- wherein the first and the second structural element (11, 12) are in an idle position spaced apart from one another by a gap (3).

10. The device according to claim 7,
**characterized in that**
- the second component (5) is rigidly connected to a base body of the device,
- a first structural element (11) is rigidly connected to the first component (4), and
- a second structural element (12) is connected to the base body by means of one or more first elastic connections (8),
- wherein the first and the second structural element (11, 12) are in an idle position spaced apart from one another by a gap (3).

11. The device according to one of claims 7-10,
**characterized in**
**that** the first component (4) or first subcomponent (1a) is fixed on the second component (5) or second subcomponent (1b) by means of the protruding layer area only.

12. The device according to one of claims 9-11,
**characterized in**
**that** the first and the second structural element (11, 12) are realized in the form of electrodes or carry electrodes.

## Revendications

1. Procédé pour la fixation d'un premier composant mobile (4) d'un élément de construction micromécanique sur un deuxième composant fixe ou mobile (5) de l'élément de construction, une surface latérale du premier composant et une surface latérale du deuxième composant étant disposées l'une en face de l'autre, dans lequel
- une couche (10) faisant saillie avec une région de couche au-delà de la surface latérale est réalisée lors de la fabrication de l'élément de construction sur un côté du premier et/ou du deuxième composant (4, 5) adjacent à la surface latérale, et
- le premier composant (4) est déplacé contre le deuxième composant pour la fixation, de telle façon que la région de couche faisant saillie est poussée par-dessus le côté du premier ou du deuxième composant (4, 5) adjacent à la surface latérale, ou, en présence d'une couche (10) faisant saillie dans les deux composants (4, 5), les régions de couche faisant saillie sont poussées l'une par-dessus l'autre, de manière à ce qu'en raison de l'adhérence, la région de couche faisant saillie adhère au composant (4, 5) sous-jacent, ou les régions de couche faisant saillie adhèrent l'une à l'autre.

2. Procédé selon la revendication 1, pour le réglage d'une distance d'espacement entre deux éléments de structure (11, 12) de l'élément de construction micromécanique, dans lequel
- le deuxième composant (5) est relié fixement au corps de base de l'élément de construction,
- un premier (11) des deux éléments de structure est relié au premier composant mobile (4) par une ou plusieurs premières jonctions élastiques (8),
- un deuxième (12) des deux éléments de structure est relié au corps de base fixement ou par un ou plusieurs deuxièmes jonctions élastiques (8), et
- lors de la fabrication de l'élément de construction, le deuxième composant (5) et le premier composant mobile (4) sont conçus et disposés de telle façon, que la distance d'espacement prédéfinie entre les deux éléments de construction (11, 12) peut être obtenue par la fixation du premier composant mobile (4) sur le deuxième composant (5).

3. Procédé selon la revendication 1, pour le réglage d'une distance d'espacement prédéfinissable entre deux éléments de structure (11, 12) de l'élément de construction micromécanique, dans lequel
- le deuxième composant (5) est relié fixement au corps de base de l'élément de construction,
- un premier (11) des deux éléments de structure est relié fixement au premier composant mobile (4), et
- un deuxième (12) des deux éléments de structure est relié au corps de base par une ou plusieurs premières jonctions élastiques (8),
- lors de la fabrication de l'élément de construction, le deuxième composant (5) et le premier composant mobile (4) sont conçus et disposés de telle façon, la distance d'espacement prédéfinie entre les deux éléments de structure (11, 12) peut être obtenue après la fixation du premier composant mobile (4) sur le deuxième composant (5).

4. Procédé selon la revendication 1, pour le réglage d'une distance d'espacement prédéfinissable entre un élément de structure mobile et deux éléments de structure disposés fixement (2a, 2b) de l'élément de construction micromécanique, dans lequel
- l'élément de structure mobile est tout d'abord réalisé à partir de deux moitiés déplaçables l'une par rapport à l'autre (1a, 1b), lesquelles sont formées par le premier composant mobile (4) et le deuxième composant (5),
- les deux éléments de structure disposés fixement (2a, 2b) sont reliés fixement au corps de base de l'élément de construction, et disposés respectivement à distance des deux moitiés déplaçables l'une par rapport à l'autre (1a, 1b) de l'élément de structure mobile, et
- lors de la fabrication de l'élément de construction, le premier composant mobile (4) et le deuxième composant (5) sont conçus et disposés de telle façon, que la distance d'espacement prédéfinie entre l'élément de structure mobile et les deux éléments de structure disposés fixement (2a, 2b) est obtenue après la fixation du premier composant mobile (4) sur le deuxième composant (5) .

5. Procédé selon l'une des revendications 1 à 4,
**caractérisé en ce que**
la couche faisant saillie (10) présente une épaisseur ≤ 2 µm et fait saillie sur une distance ≤ 5 µm au-delà de la surface latérale.

6. Procédé selon l'une des revendications 1 à 5, **caractérisé en ce que**
la force de la jonction adhésive de la région de couche faisant saillie sur le composant (4, 5) sous-jacent ou entre les régions de couche faisant saillie est augmentée par l'action d'une énergie entraînant une migration de matériau locale au niveau de la jonction.

7. Élément de construction micromécanique avec un premier composant (4) fixé de façon permanente à un deuxième composant fixe (5) de l'élément de construction lors d'une utilisation conforme de l'élément de construction, une surface latérale du premier composant et une surface latérale du deuxième composant étant disposées l'une en face de l'autre,
**caractérisé en ce que**
le premier composant (4) est fixé au deuxième composant (5) par une couche faisant saillie (10), laquelle est formée sur un côté du premier et/ou du deuxième composant (4, 5) adjacent à la surface latérale et fait saillie avec une région de couche au-delà de la surface latérale,
dans lequel la région de couche faisant saillie est poussée par-dessus le côté du premier et/ou du deuxième composant (4, 5) adjacent à la surface latérale, ou, en présence d'une couche faisant saillie (10) dans les deux composants (4, 5), les régions de couche faisant saillie sont poussées l'une par-dessus l'autre.

8. Élément de construction micromécanique avec un élément de structure mobile assemblé à partir d'un premier et d'un deuxième composant partiel (1a, 1b), une surface latérale du premier composant partiel et une surface latérale du deuxième composant partiel étant disposées l'une en face de l'autre,
**caractérisé en ce que**
le premier composant partiel (1a) est fixé au deuxième composant partiel (1b) par une couche faisant saillie (10), laquelle est formée sur un côté du premier et/ou du deuxième composant partiel (1a, 1b) adjacent à la surface latérale, et fait saillie avec une région de couche au-delà de la surface latérale,
dans lequel la région de couche faisant saillie est poussée par-dessus le côté du premier et/ou du deuxième composant (1a, 1b) adjacent à la surface latérale, ou, en présence d'une couche faisant saillie (10) dans les deux composants partiels (1a, 1b), les régions de couche faisant saillie sont poussées l'une par-dessus l'autre.

9. Élément de construction selon la revendication 7,
**caractérisé en ce que**
- le deuxième composant (5) est relié fixement au corps de base de l'élément de construction,
- un premier élément de structure (11) est relié au premier composant (4) par une ou plusieurs premières jonctions élastiques (8), et
- un deuxième élément de structure (12) est relié au corps de base fixement ou par une ou plusieurs deuxièmes jonctions élastiques (8),
- le premier et le deuxième élément de structure (11, 12) étant espacés l'un de l'autre par une fente (3) dans une position de repos.

10. Élément de construction selon la revendication 7,
**caractérisé en ce que**
- le deuxième composant (5) est relié fixement au corps de base de l'élément de construction,
- un premier élément de structure (11) est relié fixement au premier composant (4),
- un deuxième élément de structure (12) est relié au corps de base par une ou plusieurs premières jonctions élastiques (8), et
- le premier et le deuxième élément de structure (11, 12) sont espacés l'un de l'autre par une fente (3) dans une position de repos.

11. Élément de construction selon l'une des revendications 7 à 10,
**caractérisé en ce que**
le premier composant (4) ou le premier composant partiel (1a) est fixé au deuxième composant (5) ou au deuxième composant partiel (1b) uniquement par la région de couche faisant saillie.

12. Élément de construction selon l'une des revendications 9 à 11, **caractérisé en ce que**
le premier et le deuxième élément de structure (11, 12) sont conçus comme des électrodes ou portent des électrodes.
